(19) Europäisches Patentamt
European Patent Office
Office européen des brevets

(11) **EP 4 334 703 B1**

(12) **EUROPÄISCHE PATENTSCHRIFT**

(45) Veröffentlichungstag und Bekanntmachung des Hinweises auf die Patenterteilung:
**20.05.2026   Patentblatt 2026/21**

(21) Anmeldenummer: **22728161.5**

(22) Anmeldetag: **06.05.2022**

(51) Internationale Patentklassifikation (IPC):
**G01N 17/02** *(2006.01)*          **C23F 13/04** *(2006.01)*
**F16L 55/26** *(2006.01)*          **F16L 58/00** *(2006.01)*

(52) Gemeinsame Patentklassifikation (CPC):
**G01N 17/02; C23F 13/04; F16L 55/26; F16L 58/00;**
C23F 2201/00; C23F 2213/32; F16L 2101/30

(86) Internationale Anmeldenummer:
**PCT/EP2022/062342**

(87) Internationale Veröffentlichungsnummer:
**WO 2022/234117 (10.11.2022 Gazette 2022/45)**

(54) **VERFAHREN UND INSPEKTIONSVORRICHTUNG ZUR UNTERSUCHUNG DES KATHODENSCHUTZES EINER INSBESONDERE FERROMAGNETISCHEN ROHRLEITUNG**

METHOD AND INSPECTION DEVICE FOR EXAMINING THE CATHODIC PROTECTION OF A, MORE PARTICULARLY FERROMAGNETIC, PIPELINE

PROCÉDÉ ET DISPOSITIF D'INSPECTION POUR L'EXAMEN DE LA PROTECTION CATHODIQUE D'UNE CANALISATION, PLUS PARTICULIÈREMENT FERROMAGNÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität:  **07.05.2021   BE 202105375**

(43) Veröffentlichungstag der Anmeldung:
**13.03.2024   Patentblatt 2024/11**

(73) Patentinhaber: **Rosen IP AG**
**6370 Stans (CH)**

(72) Erfinder:
• **DANILOV, Andrey**
  **49809 Lingen (DE)**

• **BOSSE, Ben**
  **49808 Lingen (DE)**
• **ROSEN, Patrik**
  **49716 Meppen (DE)**

(74) Vertreter: **Wischmeyer, André et al**
**Busse & Busse**
**Patent- und Rechtsanwälte**
**Partnerschaft**
**Großhandelsring 6**
**49084 Osnabrück (DE)**

(56) Entgegenhaltungen:
**WO-A1-2019/156584     WO-A2-2014/096942**
**US-A- 4 061 965     US-A- 5 087 873**

## Beschreibung

Die vorliegende Erfindung betrifft ein Verfahren zur Untersuchung des Kathodenschutzes einer metallischen und insbesondere ferromagnetischen Rohrleitung. Weiterhin betrifft die Erfindung eine Inspektionsvorrichtung zur Untersuchung des Kathodenschutzes einer insbesondere ferromagnetischen Rohrleitung, wobei die Inspektionsvorrichtung rohrleitungsgängig und insbesondere mediumgetrieben ausgebildet ist und eine Magnetisiervorrichtung zur Erzeugung eines magnetischen Wechselfeldes mit zumindest einer Magneteinheit und eine wenigstens einen Magnetfeldsensor aufweisende Messvorrichtung zur Messung eines an der Innenseite der Wand der Rohrleitung ausgebildeten Magnetfelds aufweist.

Metallische Rohrleitungen werden oft im Boden oder im Wasser verlegt. Diese Umgebungen stellen in der Regel ein elektrolytisches Medium dar. An Fehlstellen der Beschichtung der Rohrleitung entsteht ein Ladungstransport vom Metall der Rohrleitung in Richtung des Elektrolyten. Durch den Transport von Metallionen korrodiert die Rohrleitung. Um die Korrosionsentwicklung zu verhindern, wird im Stand der Technik ein Gleichstrom auf die zu schützenden Rohrleitungen aufgebracht. Dieser Schutzstrom erzeugt eine kathodische Polarisation der Rohrleitung und verhindert, dass Metallionen von der Rohroberfläche gelöst werden.

Versagt dieser sogenannte Kathodenschutz, kann sich die Korrosion an den Beschichtungsfehlstellen in den Rohrleitungswänden sehr schnell entwickeln. Daher erfolgt die Überprüfung des kathodischen Schutzes in relativ kleinen Abständen von einem oder wenigen Monaten. Darüber hinaus helfen solche Inspektionen, die Beschichtungsfehlstellen rechtzeitig zu finden und zu beseitigen. Ein Loch einer als beispielsweise als Öl- oder Gas-Pipeline ausgebildeten Rohrleitung kann zu verheerenden Umweltschäden führen.

Der Kathodenschutz wird in der Regel an einigen kritischen Messpunkten durch Messung des Anlage-Boden-Potentials überprüft. An den Messstellen werden die entsprechenden Vorrichtungen stationär installiert. Zusätzlich kann das Potentialfeld an der Oberfläche entlang der Pipeline und in der Pipelineumgebung gemessen werden. Für Offshore-Pipelines werden Potentialmessungen mit Hilfe von ferngesteuerten Unterwasserfahrzeugen durchgeführt. Die Potentialmessung ist in der Regel sehr teuer und mit großem manuellen Aufwand verbunden.

Eine weitere Methode zur Überprüfung des Kathodenschutzes basiert auf der Messung des Gleichstroms direkt in der Rohrleitungswand mit einer rohrleitungsgängigen, d.h. in der Rohrleitung bewegbaren Inspektionsvorrichtung, welche auch als Molch bezeichnet wird. Dieser Ansatz ermöglicht Messungen entlang der gesamten Rohrleitung und stellt eine kostengünstige, zuverlässige Methode zur Abschätzung der Effizienz des kathodischen Schutzes und zur Detektion von Beschichtungsfehlern dar. Allerdings erfordert die Messung ein robustes Verfahren, das auch unter schwierigen Messbedingungen einer beispielsweise als Öl-Pipeline ausgebildeten Rohrleitung eingesetzt werden kann.

Eine im Stand der Technik bekannte Methode zur Messung der Stromstärke mit einem Molch basiert auf der Messung von Potentialwerten in der Rohrleitungswand vor und hinter einer in Längsrichtung der Rohrleitung durch diese bewegte Inspektionsvorrichtung. Aus der gemessenen Potentialdifferenz können die Ströme in der Rohrleitungswand und die Potentialverteilung entlang der Rohrleitung bestimmt werden. Allerdings benötigt der Ansatz für eine zuverlässige Messung einen guten galvanischen Kontakt mit der Wand. Für die Messung muss die Rohrleitung daher gut gereinigt werden. Bei Rohrleitungen mit Innenbeschichtung und/oder einem in der Rohrleitung transportierten Ölmedium ist eine solche Messung in der Regel nicht möglich.

Die WO 2014/096942 A2 offenbart eine Inspektionsvorrichtung mit einer Magnetisiervorrichtung, die Teil eines Odometers ist.

Die WO 2019/156584 A1 offenbart ein Verfahren zur Messung des Kathodenschutzes, bei dem ein Magnet innerhalb der Rohrleitung eine axial asymmetrische magnetische Sättigung herbeiführt. Aus dem resultierenden Magnetfeld wird der Kartonschutz abgeschätzt.

Es ist die Aufgabe der vorliegenden Erfindung, ein kostengünstiges und zuverlässiges Verfahren sowie eine zugehörige Inspektionsvorrichtung zur Untersuchung des Kathodenschutzes einer Rohrleitung zu schaffen.

Die Aufgabe wird gelöst durch ein Verfahren nach Anspruch 1 sowie durch einen Gegenstand nach Anspruch 12. Vorteilhafte Ausgestaltungen der Erfindung sind den jeweiligen Unteransprüchen sowie der nachfolgenden Beschreibung zu entnehmen.

Bei dem erfindungsgemäßen Verfahren zur Untersuchung des Kathodenschutzes einer ferromagnetischen Rohrleitung wird ein primäres magnetisches Wechselfeld und hiermit eine lokale Änderung der Permeabilität in der Wand der Rohrleitung mittels einer Magnetisiervorrichtung einer durch die Rohrleitung bewegten Inspektionsvorrichtung erzeugt. Gleichzeitig ist in der Wand der Rohrleitung ein durch einen Gleichstrom des Kathodenschutzes verursachtes sekundäres Gleichstrom-Magnetfeld ausgebildet. Weiterhin wird ein resultierendes Magnetfeld, welches sich durch Überlagerung des primären Wechselfeldes und des sekundären Gleichstrom-Magnetfeldes ergibt, mittels einer durch die Rohrleitung bewegten, zumindest einen Magnetfeldsensor aufweisenden Messvorrichtung, die insbesondere ebenfalls Teil der Inspektionsvorrichtung ist, gemessen. Weiterhin erfolgt eine Analyse der Signalanteile zumindest des sekundären Gleichstrom-Magnetfelds unter Berücksichtigung der Änderung der Permeabilität in einer EDV-Vorrichtung. Das Ableiten der Größe des Gleichstroms erfolgt auf Basis der Signalanteile des sekundären Magnetfelds. Die Analyse der Signalanteile erfolgt typischerweise nach einem Auslesen der Daten aus der Inspektionsvorrichtung, nachdem diese den Inspektionslauf beendet hat, und einem Einspielen in die EDV-Vorrichtung. Als EDV-Vorrichtungen kommen sowohl im Feld verwendete Laptops, Destop-PCs als auch Server in Frage, auf denen jeweils eine zugehörige Auswertungssoftware läuft. Diese hat insbesondere Zugriff auf die jeweiligen Arbeits- und Permanentspeicher, die jeweiligen Prozessoren und Schnittstellen zum Datentransfer zwischen den benötigten EDV-Mitteln. Ebenfalls können Datenbanken lokal oder cloudbasiert angebunden sein, in denen für die Auswertung notwendige Daten, insbesondere Kalibrierdaten, vorgehalten werden.

Der Erfindung liegt die Erkenntnis zugrunde, dass das Anlegen eines stärkeren Magnetfeldes an die Rohrleitungswand die magnetische Permeabilität in diesem Bereich der Rohrleitungswand ändert und das dann aufgrund der inhomogenen Verteilung der magnetischen Permeabilität der ansonsten nicht innerhalb der Rohrleitungswand messbare magnetische Streufluss des Gleichstroms in das Innere der Rohrleitung dringen und von der Innenseite der Rohrleitung, d.h. durch ein in der Rohrleitung bewegtes Messgerät gemessen werden kann.

Für die Beschreibung der vorliegenden Erfindung wird das sekundäre Gleichstrom-Magnetfeld der Einfachheit halber auch als sekundäres Magnetfeld bezeichnet.

Das resultierende Magnetfeld in der Rohrleitung ist eine Summe aus dem durch das äußere starke Magnetfeld und dem durch den Gleichstrom in der Rohrleitungswand induzierten Magnetfeld. Die Magnetisiervorrichtung wird in Abhängigkeit der Wanddicke und des Materials so ausgebildet, dass eine möglichst große Änderung der Permeabilität erreicht wird, so dass durch Überlagern des primären Wechselfeldes mit einem durch den Gleichstrom erzeugten sekundären Magnetfeld, welches aufgrund der lokalen Permeabilitätsänderung und der hiermit einhergehenden inhomogenen Verteilung der magnetischen Permeabilität mit einem (Streu-)Flussanteil in das Rohrleitungsinnere reicht, ein auswertbares Signal erzeugt wird und die Größe des Gleichstroms auf Basis der Signalanteile des sekundären Magnetfelds erfolgt. So kann auf einfache Weise und ohne die bisherigen Limitierungen durch beispielsweise Öl-verschmutzte, innere Oberflächen der Rohrleitungswand über die gesamte Strecke einer Rohrleitung der Gleichstrom indirekt gemessen und bestimmt werden.

Das Ableiten der Größe des Gleichstroms erfolgt insbesondere durch Vergleich der bestimmten Signalanteile mit den Daten einer Kalibrierungsdatenbank, die für eine Vielzahl von Magnetfeldstärken, Materialien, Rohrleitungswandstärken und/oder Gleichstromgrößen die sich auf der Innenseite einer Rohrleitung wandnah ergebenen Streuflussanteile des sekundären Magnetfelds umfasst.

Die Stärke des lokal durch eine Magnetisiervorrichtung erzeugten magnetischen Wechselfelds ist insbesondere zumindest um einen Faktor 50, vorzugsweise zumindest um einen Faktor 100 und weiter vorzugsweise um einen Faktor 500 größer als die Stärke des Gleichstrom-Magnetfelds. Um eine ausreichende Änderung der magnetischen Permeabilität zu erreichen, wird somit ein starkes primäres Magnetfeld induziert. Das induzierte sekundäre Magnetfeld ist im Verhältnis zum primären Magnetfeld sehr klein. Aufgrund der Erkenntnis, dass die magnetische Permeabilität nur von der Amplitude des angelegten Magnetfeldes abhängt, variiert sie allerdings doppelt so schnell wie das primäre Magnetfeld. Das sekundäre Magnetfeld ändert sich mit der gleichen Geschwindigkeit wie die magnetische Permeabilität, d.h. es variiert doppelt so schnell wie das primäre Magnetfeld, was zur Identifikation der Signalanteile des sekundären Magnetfelds verwendet wird.

Vorzugsweise liegen die Frequenzen des eingebrachten magnetischen Wechselfeldes kleiner 500 Hz, wobei sie insbesondere größer als 5 Hz sind. Unterhalb von 500 Hz lassen sich die Effekte besonders gut beobachten.

Insbesondere erfolgt die Messung des sich aus dem primären und sekundären Magnetfeld ergebenden Magnetfeldes während der Erzeugung des Wechselfeldes, so dass der zeitliche Verlauf des gemessenen Signals während der Erzeugung des Wechselfeldes aufgenommen und ausgewertet werden kann.

Vorzugsweise wird in der EDV-Vorrichtung das Spektrum des sekundären Magnetfeldes bestimmt, wobei es sich zunächst um die Analyse des gesamten Signals handeln kann, aus welchem dann die Signalanteile des sekundären Feldes abgeleitet werden. Die an sich bekannte Spektralanalyse, beispielweise in Form einer Fourier-Analyse, wird nun für die Bestimmung eines eigentlich innenseitig der Rohrleitungswand sonst nicht messbaren äußeren Gleichstrommagnetfeldes verwendet.

Vorzugsweise wird in der Analyse für die Bestimmung des Gleichstroms zumindest ein Signalanteil ausgewählt wird, der ein gerades Vielfaches der Frequenz der Richtungsänderung des Magnetfeldes ist. Insbesondere werden in der Spektralanalyse alle Signalanteile berücksichtigt, die einem geraden Vielfachen der Frequenz der Richtungsänderung des Wechselfeldes entsprechen, wobei die Nullfrequenz nicht berücksichtigt wird. Die Frequenz der Stärke des sekundären Magnetfeldes $H_s$ (t) ist doppelt so groß wie die Frequenz der Stärke des primären Magnetfeldes $H_p$ (t). Dieser Unterschied in der Variation erlaubt es, die Signale $H_p$ (t) und $H_s$ (t) im Frequenzraum zu trennen. Aus dem Signal des sekundären Feldes wird wiederum die Stromstärke des Kathodenschutzes abgeleitet.

Zwecks genauer Auswertung werden insbesondere Signallängen von 5 bis 15 Hauptperioden des angelegten Wechselfeldes berücksichtigt.

Insbesondere wird in der EDV-Vorrichtung auf Basis der Amplitude zumindest eines geraden Vielfachen der Frequenz der Richtungsänderung des Magnetfeldes die Stromstärke mittels einer oder mehrerer Regressionsfunktionen bestimmt. Die eine oder mehreren Regressionsfunktionen werden insbesondere in Abhängigkeit der vorliegenden Randbedingungen, insbesondere der Wandstärke der Rohrleitung, des Materials derselben, des aufgeprägten Magnetfelds, der Geschwindigkeit der Messvorrichtung und/oder des Setups der zugehörigen Magnetfelderzeugungsvorrichtung bestimmt. Vorzugsweise werden hierbei die Analysedaten des sekundären Magnetfeldes mittels der Analysedaten des primären Magnetfeldes normalisiert und/oder kalibriert.

Um die Stromstärke $I$ des Kathodenschutzes zu berechnen, kann beispielsweise eine Regressionsfunktion des Merkmalsvektors $V = \left[\frac{F(2f_m)}{F(f_m)}, \frac{F(4f_m)}{F(f_m)}, \frac{F(6f_m)}{F(f_m)}, \frac{F(8f_m)}{F(f_m)}\right]$ bestimmt werden, wobei F( ) die Amplituden des jeweiligen Spektrums sind. Die einzelnen Werte aus dem Spektrum sind auf den Hauptfrequenzwert aus dem Signalspektrum normiert. Diese Normalisierung reduziert die Abhängigkeit von der Variation der Magnetisierungsstärke und $I = R(V)$, wobei R für die Regressionsfunktion steht.

Zur Definition der Regressionsfunktion können insbesondere eine Fit-Funktion oder gängige Methoden des maschinellen Lernens wie lineare Regression, neuronale Netze, Entscheidungsbäume, Support-Vektor-Maschine usw. verwendet werden. Zur Definition der Regressionsfunktion können Daten im Rahmen einer Kalibrierung gewonnen werden. Je nach Geräteausführung kann es notwendig sein, unterschiedliche Regressionsfunktionen für verschiedene Messbedingungen wie Wandstärke $wt$, magnetische Eigenschaften des Rohrleitungsmaterials und Geschwindigkeit v der Messvorrichtung zu definieren.

$$I = \begin{cases} R_1(V) \text{ wenn } wt = wt_1, v = v_1, \dots \\ R_2(V) \text{ wenn } wt = wt_2, v = v_2, \dots \\ \qquad \dots \end{cases}$$

Diese Abhängigkeiten können auch als zusätzliche Parameter in die Regressionsfunktion eingeführt werden, d.h. $I = R(V, wt, v, \dots)$. Der Strom $I$ kann demnach wie folgt definiert werden.

$$I = \begin{cases} R_1(V, wt, v) \text{ für Stahl st37} \\ R_2(V, wt, v) \text{ für Stahl st52} \\ \qquad \dots \end{cases}$$

Eine Kalibrierung kann ebenfalls über die Änderung der Amplituden der ungeraden Frequenzen und/oder mittels der B-H-Kurven der ungeraden Frequenzen erfolgen.

Die Messbedingungen können durch den Verlauf der primären Magnetisierung definiert werden. Es kann ausreichen, hierfür das gemessene Signal direkt zu verwenden, unter Vernachlässigung des Teils der sekundären Magnetisierung. Ebenfalls ist es möglich, die Frequenzen $2f_m$, $4f_m$, $6f_m$, $8f_m$, ... aus dem Signal zu filtern, um den Einfluss der sekundäres Magnetfeldes auszuschließen. Insbesondere erfolgt gemäß einer weiteren vorteilhaften Weiterbildung in der EDV-Vorrichtung die Bestimmung der Messbedingungen auf Basis eines Spektrums des primären Wechselfeldes, so dass separate, zusätzliche Arbeits- oder Messvorgänge zur Bestimmung der Messbedingungen entfallen können.

Einige der Messbedingungen können gleichwohl bekannt sein oder auch durch andere Messmethoden gegebenenfalls redundant vorab bestimmt werden.

Vorzugsweise wird bei einer Weiterbildung des erfindungsgemäßen Verfahrens für eine oder während eines Messlaufes der Inspektionsvorrichtung die Spannung des Kathodenschutzes variiert und zumindest erhöht. Infolge der Erhöhung wird die Stromstärke in der Rohrleitungswand größer und das sekundäre Magnetfeld steigt an. Insbesondere kann der Spannungsverlauf ein Signalmuster zur besseren Identifikation des entsprechenden Gleichstrom-Magnetfeldanteils aufweisen.

Eine weitere Möglichkeit, die Trennung der Signale des primären und des sekundären Magnetfelds zu verbessern, besteht darin, das Gerät so zu konfigurieren, dass das Spektrum des primären Magnetfeldes im Fourier-Spektrum hauptsächlich durch die Hauptfrequenzkomponente vertreten wird. Dadurch wird es im Fourier-Spektrum leichter, die Signale von primären und sekundären Magnetfeldern zu trennen.

Insbesondere wird für die Bestimmung der Stromstärke eine Vielzahl von Daten eines Messlaufes fusioniert. Wenn die Beschichtung einer Rohrleitung unbeschädigt ist, ändert sich die Stromstärke sehr langsam und kann sich nur bei Beschichtungsfehlern und Installationen schlagartig ändern. Dies ermöglicht eine genauere Abschätzung der Stromstärke durch Datenfusion der Daten aus einem Lauf, z.B. mittels Kalman-Filter.

Vorzugsweise können die gesammelten Messdaten aus mehreren Läufen fusioniert werden, um die Genauigkeit der Auswertung weiter zu verbessern.

Gemäß einer Weiterbildung der Erfindung erfolgt die Messung des sich ergebenden Magnetfelds mit wenigstens einem zumindest im Wesentlichen in einem festen Abstand zur Wand positionierten Magnetfeldsensor, insbesondere wobei der Abstand zumindest einer Magneteinheit der Magnetisiervorrichtung zur Innenseite der Wand variiert. "Im Messzeitpunkt zumindest im Wesentlichen in einem festen Abstand zur Wand positioniert" bedeutet, dass der Sensor zum Messzeitpunkt konstruktiv in einen festen Abstand zur Wand gehalten werden kann, allerdings aufgrund der Bewegung der den Magnetfeldsensor aufweisenden Inspektionsvorrichtung durch die Rohrleitung leichte Variationen entstehen können, beispielsweise bedingt durch einen unsauberen Lauf aufgrund von Verschmutzungen der inneren Oberfläche der Rohrleitungswand oder aufgrund von Abheben des Sensors durch Schweißnähte.

Beispielsweise kann ein solcher Sensor bei einem sich entlang der Wand bewegenden und auf dieser abrollenden Träger durch eine Spulenwicklung entlang des abrollenden Umfangs ausgebildet sein.

Alternativ oder ergänzend kann ein Kranz von Sensoren entlang des Umfangs angeordnet sein, wobei der jeweils der Sensor ein Messsignal aufnimmt, der am nächsten an der Wand ist.

Die Magnetisiervorrichtung zur Erzeugung des primären Magnetfeldes kann eine Magneteinheit aufweisen, die durch zumindest einen Elektromagneten oder durch wenigstens einen in der Rohrleitung rotierbar angeordneten Permanentmagneten ausgebildet wird. Die Verwendung eines Elektromagneten ermöglicht eine größere Flexibilität bei der Steuerung des Verlaufs der primären Magnetisierung, erfordert jedoch viel elektrische Energie.

Vorzugsweise laufen die zumindest zwei Magneteinheiten in Längsrichtung der Rohrleitung auf einem insbesondere rollbar ausgebildeten Träger um, so dass auf einfache Weise ein alternierendes Feld erzeugt wird. Die Drehachse des Trägers steht hierbei zumindest im Mittel oder immer quer zur Rohrleitungslängsachse. Beispielsweise ist die Magnetisiervorrichtung als eine Art Magnetrad ausgebildet mit dem Rad als Träger, wobei zusätzlich der oder die Magnetfeldsensoren an, auf oder in dem Rad bzw. Träger angeordnet sind. Ergänzend kann bei einer Stand-alone-Variante einer mittels eines solchen Magnet- und Sensorrades ausgebildeten Inspektionsvorrichtung ein Stützrad vorhanden sein, wobei das Magnetrad mindestens 3x größer als ein Stützrad ist.

Insbesondere ändert sich die Magnetisierungsrichtung des auf die Wand einwirkenden Magneten entlang des Umfangs des Trägers und/oder des Drehwinkel des Trägers, so dass mit dem Abrollen des Trägers die Permeabilitätsänderung im Spektrum erkannt wird.

Vorzugsweise wird während eines Messlaufs innenwandseitig der Rohrleitung durch zwei in Längsrichtung der Rohrleitung beabstandete Kontakte ein Zusatzstrom aufgebracht wird, um mögliche Abhängigkeiten von Änderungen in der Messumgebung zu berücksichtigen. Es versteht sich, dass dies für Rohrleitungen ohne isolierende Innenbeschichtung gilt. Der zusätzliche Strom kann gemessen und zusammen mit der Signaländerung zur Korrektur der Auswertung verwendet werden.

Der gesamte Strom $I$ in einer Rohrleitung zum Beispiel wie folgt berechnet werden:

$$I = k\,P + a, \text{ hier } P = \sum_i c_i V_i.$$

P ergibt sich aus der Summe der Komponenten $V_i$ des Merkmalsvektors V, multipliziert mit einem Gewicht-ungskoeffizienten $c_i$. Die Koeffizienten $k,\ a$ und $c_i$ können während der ersten Kalibrierung des Gerätes vor dem Lauf bestimmt werden. Die Koeffizienten $c_i$ werden gerätespezifisch für alle möglichen Messumgebungen als konstant angenommen werden, $k$ und $a$ können für verschiedene Messumgebungen umdefiniert werden und in einer Datenbank gespeichert werden.

Aufgrund der typischerweise nur langsamen Änderung der Größe des Gleichstroms des Kathodenschutzes kann nach einer ersten Strecke ohne zusätzlichen Strom eine weitere Strecke mit zusätzlich durch beispielsweise die Inspektionsvorrichtung aufgebrachten Strom gemessen werden. Unter der Annahme, dass sich der Strom des Kathodenschutzes nicht geändert hat, gilt dann, dass sie Änderung $\Delta I$ des Stromes wie folgt dargestellt werden kann:

$$\Delta I = k\,\Delta P, \text{ hier } \Delta P = \sum_i c_i \Delta V_i.$$

Der Koeffizient k kann aus der Gleichung neu berechnet werden. Der korrigierte k-Wert ermöglicht eine genaue Berechnung der Änderung des Stromwertes. Der Parameter $a$ kann aus der Datenbank mit kalibrierten $k$ - und $a$-Werten bestimmt werden.

Insbesondere kann die Kalibrierung dann durchgeführt werden, wenn sich die Amplitude und/oder Form des gemessenen Magnetfelds aufgrund geänderter Rahmenbedingungen signifikant, d.h. insbesondere z.B. um zumindest 5% einer Amplitude des sinusartigen Verlaufs des gesamten gemessenen Magnetfeldes, geändert hat. Während der Kalibrierung kann die Messung fortgesetzt werden, wobei der zugeführte Strom vom gemessenen Stromwert subtrahiert werden muss.

Die eingangs gestellt Aufgabe wird ebenfalls durch eine Inspektionsvorrichtung zur Untersuchung des Kathodenschutzes einer insbesondere ferromagnetischen Rohrleitung, gelöst, wobei die Inspektionsvorrichtung rohrleitungsgängig und insbesondere mediumgetrieben ausgebildet ist und eine Magnetisiervorrichtung zur Erzeugung eines magnetischen Wechselfeldes und eine wenigstens einen Magnetfeldsensor aufweisende Messvorrichtung zur Messung eines an der Innenseite der Wand der Rohrleitung ausgebildeten Magnetfelds aufweist, und wobei die Magnetisiervorrichtung wenigstens einen im Betriebsfall durch die Rohrleitung in deren Längsrichtung rollbaren Träger aufweist, der in einem quer zu einer Drehachse verlaufenden Schnitt mit einem vorzugsweise zumindest im Wesentlichen kreisartigen Umfang versehen ist und entlang des Umfangs zumindest zwei Magneteinheiten zur Erzeugung eines magnetischen Wechselfeldes aufweist, deren Magnetfeldrichtungen zumindest teilweise und insbesondere genau einander entgegenlaufen. Eine solche Inspektionsvorrichtung ist dazu ausgebildet, die Messdaten zu erzeugen, die im vor- und/oder nachbeschriebenen erfindungsgemäßen Verfahren in der EDV-Vorrichtung zur Bestimmung des Gleichstroms des Kathodenschutzes analysiert werden.

Der Träger erzeugt während des Abrollens an der Innenseite einer Rohrleitungswand ein starkes magnetisches Wechselfeld am Berührungspunkt mit der Wand. Bei Verwendung nur genau einer Magneteinheit mit genau einem Magnetfelderzeuger sollte es sich um eine ansteuerbare Magneteinheit handeln, deren Magnetfeldrichtung sich mit jedem Umlauf bei erneuter Annäherung an die Innenseite der Rohrleitung geändert hat. Bei Verwendung zumindest zweier Magneteinheiten kann es sich um Permanentmagnete mit zueinander angewinkelten und insbesondere einander entgegengesetzten Magnetfeldrichtungen handeln. Je öfter die Magnetisierungsrichtungen wechseln, desto höher ist die Hauptfrequenz des induzierten Magnetfeldes. Insbesondere weist die Magneteinheit der Magnetisiervorrichtung vier, sechs oder acht mit entgegengesetzten Magnetfeldrichtungen versehene Permanentmagnete auf. Aus dem Umfang des rollbaren Trägers und der Anzahl der Magneteinheiten ergibt sich mit der durch das Abrollen des Trägers auf der Innenseite der (Wand der) Rohrleitung ergebenen Geschwindigkeit die Hauptfrequenz des primären Magnetfeldes.

Eine Inspektionsvorrichtung ist für die Zwecke der vorliegenden Erfindung dann mediumgetrieben ausgebildet, wenn sie während des Messlaufs zumindest einen Teil der für eine Vorwärtsbewegung in der Rohrleitung benötigte Energie über das in der Rohrleitung bewegte Medium erhalten kann.

Bei gleicher Distanz entlang einer Rohrleitungswand ermöglicht eine höhere Hauptfrequenz eine genauere Messung des Gleichstroms. So wird z.B. ein Signal mit 10 Perioden durch ein Rad mit vier Magneten mit entlang des Umfangs wechselnden Magnetfeldrichtungen durch 5 Umdrehungen erzeugt. Die Permeabilität ändert sich entsprechend dem Vorstehenden doppelt so schnell. Eine zu häufige Änderung der Magnetisierungsrichtung kann jedoch zu einer Schwächung des Magnetfeldes durch Wechselwirkung der Magnetpole oder zu einer stärkeren Verzerrung des Magnetfeldes durch die in der Röhre induzierten Wirbelströme führen, so dass die Frequenz des primären Magnetfeldes kleiner 500 Hz sein sollte.

Die Magnetisiervorrichtung kann vorzugweise mit dem rollbaren Träger Teil einer über Cups oder Discs mit dem Medium durch eine Rohrleitung voran treibbaren Inspektionsvorrichtung sein. Eine solche kann auch mehrere solcher rollbaren Träger zwecks gleichzeitiger, paralleler Messung aufweisen. Es kann sich alternativ auch um ein sogenanntes "Smart Wheel" handeln, d.h. um eine insgesamt durch die Rohrleitung rollbare Inspektionsvorrichtung, wie sie nachfolgend noch beschrieben wird.

Als Magnetfeldsensoren kommen übliche Sensoren zur Messung eines Magnetfeldes in Frage, insbesondere Spulen, die zumindest im Wesentlichen in einem festen Abstand zur Innenseite der Rohrleitungswand gehalten werden. Der rollbare Träger rollt auf seinem zumindest im Wesentlichen kreisartigen, insbesondere vollständig kreisförmigen Umfang ab, entlang dem die zumindest zwei Magneteinheiten des Trägers angeordnet sind. Als kreisartig wird ein Umfang bezeichnet, der zum kontinuierlichen Abrollen des Trägers in Richtung der Längsrichtung der Rohrleitung geeignet ist. Beispielsweise kann eine leicht elliptische Form eines Rades ebenfalls noch zu einem Abrollen führen.

Vorzugsweise umfasst die Magnetisiervorrichtung aus magnetisierbarem Material hergestellte Fokussierelemente, die bei parallel zur Drehachse des Trägers ausgerichteten Permanentmagneten das Magnetfeld in Richtung der Rohrleitung fokussieren, um mit dieser einen Magnetschluss zu bewirken. Beispielsweise sind die Magnete zumindest auf einer Seite von einer ein magnetisierbares Material aufweisenden und insbesondere in Richtung der Drehachse betrachtet vorzugsweise kreisring-oder kreisringsegmentförmigen und insbesondere magnetisierbaren Einfassung begrenzt ist, die insbesondere den Umfang mit ausbildet. Pro Pol eines Permanentmagneten kann jeweils zumindest ein Fokussierelement verwendet werden.

Vorzugsweise sind die Magnetfeldrichtungen der wenigstens einen Magneteinheit parallel oder radial zur Drehachse des Trägers ausgebildet sind, um ein in Umfangsrichtung des Trägers möglichst wenig geschlossenes Magnetfeld zu erhalten, bzw. um auch mittels der Fokussierelemente eine möglichst gute Einleitung des Magnetflusses in die Rohrleitung zu erhalten.

Vorteilhafterweise ist eine erfindungsgemäße Inspektionsvorrichtung entlang des Umfangs des Trägers mit wenigstens einem Magnetfeldsensor versehen, der an oder in dem Träger angeordnet ist. Dieser Sensor kann hinsichtlich seines Abstands fest zur Wand am Träger angeordnet sein, beispielsweise in einer Führung oder Halter des Trägers, so dass ein Teil der Messvorrichtung in einem zur wandnahen Anordnung ausgebildeten Halter angeordnet ist. Eine wandnahe Anordnung ist eine Anordnung innerhalb einer Reichweite, die die Aufnahme der gewünschten Signale ermöglicht, insbesondere ist dies eine Anordnung innerhalb eines Abstandes von 10 cm zur Innenseite der Rohrleitungswand.

Insbesondere sind Magnetisiervorrichtung und Magnetfeldsensor relativ zueinander beweglich angeordnet, so dass immer derselbe Sensor für eine Messung verwendet werden kann, was für die Auswertung und Abstimmung der Inspektionsvorrichtung vorteilhaft ist. Insbesondere ist der Träger hierfür drehbar am Halter gelagert, so dass auch eine Ausbildung als "Smart Wheel" möglich ist. Hierfür kann der Träger ergänzend über den Halter mit einem Abstützelement in Form eines Rollrades versehen sein, dessen Durchmesser höchstens 50 % des Durchmessers des Trägers beträgt, wodurch eine stabil vom Medium durch eine Rohrleitung voran treibbare Inspektionsvorrichtung ausgebildet wird.

Alternativ oder ergänzend kann erfindungsgemäß eine Vielzahl von Magnetfeldsensoren entlang des Umfangs angeordnet werden, die mit dem Träger bewegt werden, wobei über die Messsignale der einzelnen Sensoren insbesondere auch die Annäherung an die Rohrleitungswand bestimmt werden kann und somit ein Messsignal im Moment einer größten Annäherung an die Wand bestimmt und abgespeichert werden kann.

Insbesondere ist der oder ein weiterer Magnetfeldsensor als Spule mit einer oder mehreren in Umfangsrichtung verlaufenden Wicklungen ausgebildet. Insbesondere ist oder sind die Wicklungen der Spule vollumfänglich umlaufend ausgebildet, so dass eine vollständige Abdeckung eines Kreises vorliegt. Durch eine hinsichtlich der Drehachse des Trägers äquidistante Positionierung auf einem zumindest im Wesentlichen kreisrunden Träger entlang des äußeren Umfangs können während des gesamten Abrollvorgangs des Trägers Messungen durchgeführt werden. Ebenfalls können zwei Spulen neben- oder übereinander bzgl. der Drehachse angeordnet werden. Ebenfalls können mehrere Spulen in Umfangsrichtung nacheinander unterschiedliche Winkelbereiche des Trägers abdecken und so insgesamt eine vollständige oder teilweise Abdeckung um 360° um die Drehachse des Trägers herum ausbilden.

Gemäße einer weiteren vorteilhaften Ausbildung der Erfindung sind mehrere Magnetfeldsensoren vorgesehen, die insbesondere räumlich getrennt voneinander angeordnet sind und gleichzeitig messen, was eine bessere Trennung des primären und sekundären Magnetfelds ermöglicht, da sich diese unterschiedlich im Raum verteilen.

Insbesondere für eine Ausbildung in Form eines ohne Cups oder Discs antreibbaren Inspektionsvorrichtung kann diese Inspektionsvorrichtung wenigstens ein sich insbesondere von der Drehachse wegerstreckendes Vortriebselement aufweisen. So können in einer Ausbildung als "Smart Wheel" seitlich abstehende Stege zumindest temporär wie ein Segel im Medium wirken, über die ein Vortrieb ermöglicht wird. Diese Segel oder Stege können am Halter oder auch am drehbaren Träger angeordnet sein und die Inspektionsvorrichtung gegen ein vollständiges Umfallen im Betrieb sichern.

Vorzugsweise weist eine erfindungsgemäße Inspektionsvorrichtung als Stabilisierungsmittel ein oder mehrere von der Drehachse radial beabstandete Gewichte und/oder ein oder mehrere insbesondere von der Drehachse radial beabstandete Magnete vorgesehen, wobei ein jeweiliges Magnetfeld des oder der Magnete im Betriebsfall mit der Rohrleitungswand wechselwirkt, um das gewünschte primäre Wechselfeld zu erzeugen.

Insbesondere weisen die Magnete ein höheres Gewicht als radial zur Drehachse versetzte Bereiche der Inspektionsvorrichtung auf. Während ein Gewicht bereits den erzeugten Drehimpuls erhöht und somit die Einhaltung der Drehachsenrichtung begünstigt, wird durch einen oder mehrere Magnete in dem Umfang oder entlang des Umfangs der Inspektionsvorrichtung neben einer etwaigen Drehimpulserhöhung zumindest die Haftung zwischen Wand und Vorrichtung erhöht und somit ein schlupffreier Lauf stark begünstigt. Beim Rollen der Inspektionsvorrichtung wird das magnetisierbare Material der Rohrleitung magnetisiert und beim Entfernen des Magneten während des Rollens wieder entmagnetisiert, wodurch Wirbelströme entstehen, die einer Erhöhung der Laufgeschwindigkeit der Vorrichtung entgegenwirken und somit das Laufverhalten stark verbessern. Die Magnete, die das primäre Wechselfeld erzeugen, begünstigen somit einerseits schwerkraftbedingt andererseits durch die magnetische Wechselwirkung deutlich einen stabileren Lauf der Vorrichtung.

Insbesondere weist der Träger eine kugel- oder ellipsoidartige Umhüllende auf. Eine ellipsoidartige Form ist eine entweder durch genau ein Ellipsoid oder eine um wenige, d.h. kleiner 10 cm, vorzugsweise kleiner 5 cm von einem Ellipsoid abweichende Form. Weiterhin vorzugsweise sind bei der ellipsoidartigen Umhüllenden die Längen zweier insbesondere gleich langer Halbachsen größer sind als die der in der Drehachse liegenden dritten Halbachse.

Der zum Abrollen vorgesehene Umfang des Träger wird vorzugsweise durch zumindest ein zumindest teilweise aus Kunststoff hergestelltes, vorzugsweise ringförmiges und/oder elastisches Dämpfungselement und/oder durch zumindest ein Abrollelement zumindest mit ausgebildet, welches für einen möglichst erschütterungsfreien Lauf der als "Smart Wheel" ausgebildeten Inspektionsvorrichtung sorgt.

Weiterhin kann der Magnetfeldsensoren aufweisende Träger durch befüllbare Hohlräume der Inspektionsvorrichtung und/oder in den Träger integrierbare Gewichtselemente und/oder durch eine auswechselbare Tragstruktur eine veränderbare mittlere Dichte aufweisen, so dass die Inspektionsvorrichtung in unterschiedlichen Medien eingesetzt werden kann.

Weitere Vorteile und Einzelheiten der Erfindung sind der nachfolgenden Figurenbeschreibung zu entnehmen. Schematisch dargestellt zeigt:

Fig. 1 das Ergebnis einer nummerischen Simulation der durch Gleichstrom induzierten Magnetfeldstärke,

Fig. 2 eine Konfiguration von Permanentmagneten eines Versuchsaufbaus,

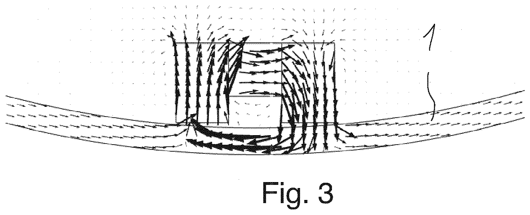

Fig. 3    den magnetischen Fluss, der durch das Setup nach Figur 2 erzeugt wird,

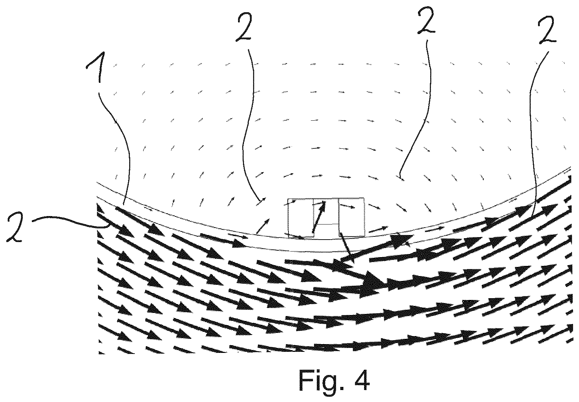

Fig. 4    einen Ausschnitt eines sekundären Magnetfelds beim Setup nach Figur 2,

Fig. 5    einen Aufbau einer Magnetisiervorrichtung eines erfindungsgemäßen Gegenstandes,

Fig. 6    eine vereinfachte Darstellung des Verlaufs der magnetischen Permeabilität $\mu$ sowie des primären und sekundären Magnetfeldes ($H_p$ und $H_s$),

Fig. 7    eine Amplitude des Magnetfeldes gemessen an der Innenseite der Wand der Rohrleitung sowie ein Spektrum des gemessenen Signals,

Fig. 8    ein Furier-Spektrum der Differenz zwischen Magnetfeldern, gemessen mit und ohne Gleichstrom,

Fig. 9    einen erfindungsgemäßen Gegenstand,

Fig. 10   eine Detailansicht des Gegenstandes nach Figur 9,

Fig. 11   eine Detailansicht eines weiteren erfindungsgemäßen Gegenstandes,

Fig. 12   eine Detailansicht eines weiteren erfindungsgemäßen Gegenstandes,

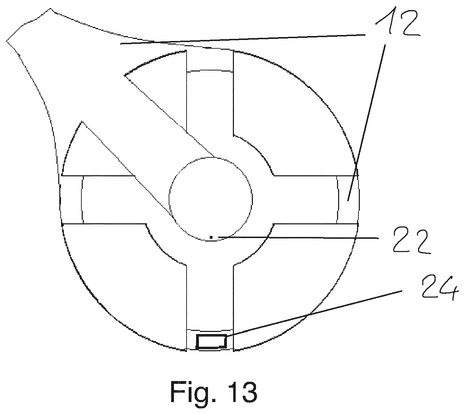

Fig. 13   eine Detailansicht eines weiteren erfindungsgemäßen Gegenstandes,

Fig. 14   einen weiteren erfindungsgemäßen Gegenstand,

Fig. 15   einen weiteren erfindungsgemäßen Gegenstand.

Die nachfolgend erläuterten Merkmale der erfindungsgemäßen Ausführungsbeispiele können auch einzeln oder in anderen Kombinationen als dargestellt oder beschrieben Gegenstand der Erfindung sein, stets aber zumindest in Kombination mit den Merkmalen eines der unabhängigen Ansprüche. Sofern sinnvoll sind funktional gleichwirkende Teile mit identischen Bezugsziffern versehen.

Zur Überprüfung des erfindungsgemäßen Verfahrens wurde zunächst eine nummerische Simulation durchgeführt, bei der in einer Wand 1 einer Rohrleitung ein Gleichstrom simuliert wird. Pfeile 2 dienen der Kennzeichnung der Magnetfeldstärke sowie deren Richtung. Je größer eine Pfeil 2 ausgebildet ist, desto größer ist an der entsprechenden Position die Magnetfeldstärke. Das magnetische Feld innerhalb der Rohrleitung ist Null.

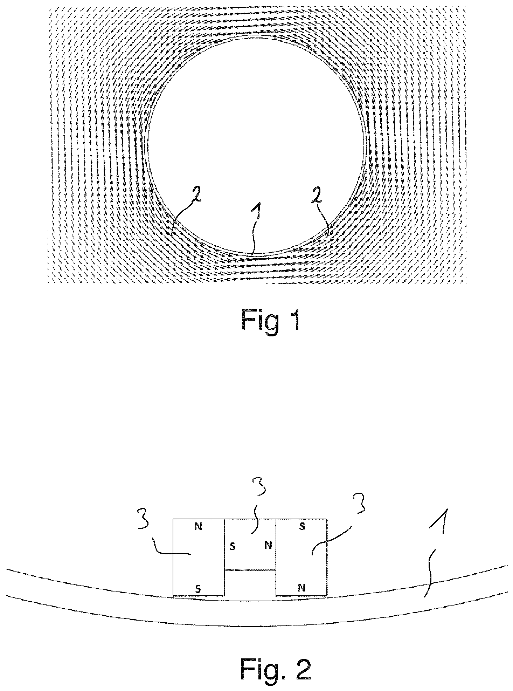

Zur weiteren Überprüfung wurde nun die magnetische Permeabilität der Rohrleitungswand 1 durch ein Dauermagnet-Setup gemäß Figur 2 variiert. Die Anordnung dreier Permanentmagneten 3 führt zur Ausbildung eines starken magnetischen Flusses durch die Wand 1 der Rohrleitung. Hierdurch wird die magnetische Permeabilität in der Wand 1 der Rohrleitung lokal stark verändert. Dies führt zum Eindringen des durch den Gleichstrom in der Wand 1 der Rohrleitung erzeugten sekundären Magnetfelds, was durch die zugehörigen Pfeile 2 auf der Innenseite der Wand 1 der Rohrleitung veranschaulicht wird.

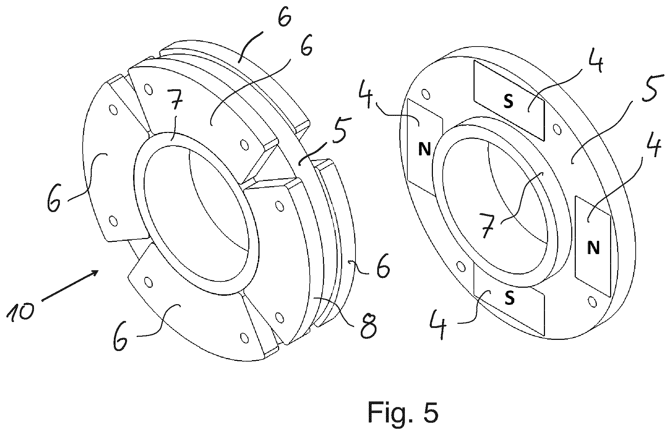

Für das erfindungsgemäße Verfahren wurde nunmehr eine erfindungsgemäße Vorrichtung mit einer Permanentmagnete 4 aufweisenden Magneteinheit einer Magnetisiervorrichtung verwendet. Im linken Teil der Figur 5 sind die Permanentmagnete in einem zugehörigen Träger 5, der auf seinem Umfang in Längsrichtung durch die Rohrleitung rollen kann dargestellt. Die Magnetfeldrichtung in Umfangsrichtung aufeinander folgende Permanentmagnete ist jeweils entgegengesetzt, so dass sich die in Figur 5 erkennbare Abfolge der Nord- und Südpole in Umfangsrichtung ergibt. Der Träger 5, in dem die Magnete 4 angeordnet sind, kann aus einem nichtmagnetischen Material ausgebildet sein und dreht um eine Drehachse 38. Zwecks Ausrichtung der Magnetfelder eines jeweiligen Permanentmagneten 4 sind beidseits an Nord- und Südpol eines Permanentmagneten Fokussierelemente 6 angeordnet, die den Magnetfeldfluss in Richtung der inneren Oberfläche der Wand 1 der Rohrleitung richten. Bei diesen Fokussierelementen handelt es sich um kreisringsegmentförmige Fokussierelemente 6, die aus einem magnetisierbaren Material bestehen. Sie sind einerseits an dem Träger 5 befestigt und liegen innenseitig auf einem Flansch 7 des Trägers auf. Die radial nach außen gerichteten Oberflächen 8 der Fokussierelemente 6 stehen etwas über den äußeren Umfang des Trägers 5 über, so dass dessen äußerste Oberfläche nicht mit der Wand der Rohrleitung bzw. Pipeline in Verbindung gelangt, sondern nur entlang seines Umfangs auf dieser abrollt.

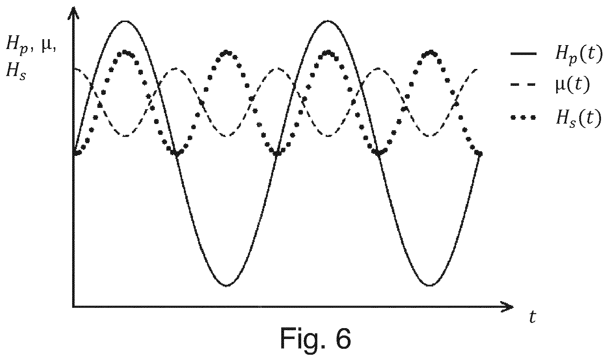

Durch das Abrollen der Magnetisiervorrichtung in Form eines Magnetrades ergibt sich in der Wand der Rohrleitung betrachtet mit dem Verlauf des Rades der in Figur 6 dargestellte Verlauf des primären Magnetfeldes $H_p$ (t). Durch

die Abhängigkeit der Permeabilität μ von lediglich dem Betrag des primären Magnetfeldes $H_p$ ist die Frequenz des Signals doppelt so groß wie die des primären Magnetfeldes. Entsprechend ergibt sich der zeitliche Verlauf μ (t), wie er ebenfalls in Figur 6 dargestellt ist. Durch die lokale Änderung der Permeabilität ergibt sich unter der Bedingung, dass die äußeren Rahmenbedingungen gleichbleiben und beispielsweise keine Fehlstellen vorliegen dann wiederum der auf der Innenseite der Rohrleitung messbare Verlauf des sekundären Magnetfeldes $H_s$.

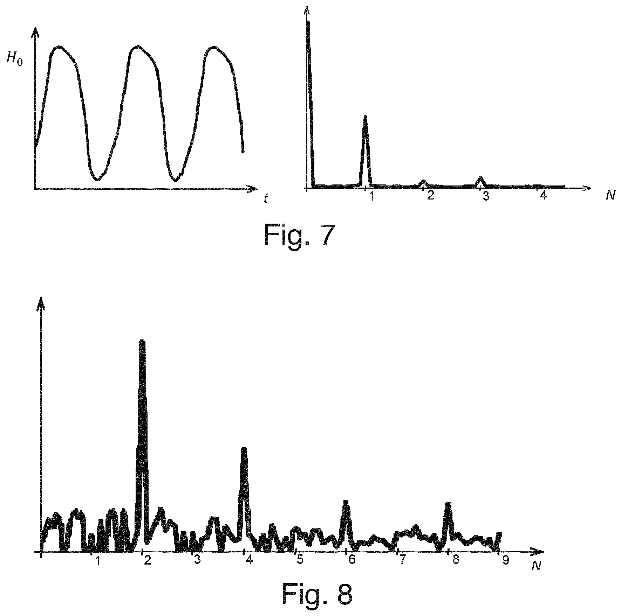

Eine Magnetisiervorrichtung nach Figur 5 bewirkt das an der Innenfläche der Rohrleitungswand gemessene Magnetfeld gemäß dem linken Teil der Figur 7, wobei in der Rohrleitungswand kein Gleichstrom eines Kathodenschutzes angelegt war. Eine Spektralanalyse zeigt dann bei N=1 den Peak der Hauptfrequenz im rechten Teil der Figur 7. N ist ein Vielfaches der Hautfrequenz $f_m$. Die kleineren Peaks bei N=2 und N=3 ergeben sich aus den Messungenauigkeiten, da es sich um kein ideales System handelt.

Wird nun ein Gleichstrom in der Wand der Rohrleitung angelegt, ebenfalls wieder das sich an der Innenfläche der Rohrleitungswand ergebende Magnetfeld gemessen sowie anschließend im Spektrum die Differenz des Feldes mit und des Feldes ohne Gleichstrom gebildet, so ergibt sich das in der Figur 8 dargestellte Fourier-Spektrum. Deutlich erkennbar sind die Peaks bei N=2, N=4, N=6 und N=8, die sich durch das sekundäre Magnetfeld, welches sich aufgrund der lokalen Änderungen der Permeabilität in das Rohrinnere erstreckt, ergeben. Mit Ausnahme der Nullfrequenz hat der Maximalwert eine Frequenz, die der Frequenz der Richtungsänderung des Magnetfeldes entspricht. Bei dem in Figur dargestellten Magnetrad ändert sich die magnetische Richtung vier Mal pro Umdrehung. Während nun das Spektrum des primären Magnetfeldes durch ganze Vielfache von $f_m=2*v/(\pi*D)$ bestimmt wird (mit D dem Durchmesser des Magnetrades, v der Geschwindigkeit des Mittelpunktes des Magnetrades), wird das Spektrum des sekundären Magnetfeldes durch Frequenzen repräsentiert, die Vielfache von $2*f_m$ sind. Das Spektrum wird umso genauer, je länger das für die Berechnung ausgeschnittene Signal ist. Vorzugsweise werden Signallängen von 6 bis 12 Hauptperioden zur Auswertung verwendet.

Die primären und sekundären magnetischen Felder verteilen sich unterschiedlich im Raum. Zur besseren Trennung der primären und sekundären Magnetfelder können mehrere Magnetfeldsensoren an unterschiedlichen Positionen installiert werden. Die aufgezeichneten Signale können zum Aufbau eines kombinierten Merkmalsvektors verwendet werden.

$$V = \left[\frac{F_1(2f_m)}{F_1(f_m)}, \frac{F_1(4f_m)}{F_1(f_m)}, \frac{F_1(6f_m)}{F_1(f_m)}, \frac{F_1(8f_m)}{F_1(f_m)}, ..., \frac{F_n(2f_m)}{F_n(f_m)}, \frac{F_n(4f_m)}{F_n(f_m)}, \frac{F_n(6f_m)}{F_n(f_m)}, \frac{F_n(8f_m)}{F_n(f_m)}\right],$$

wobei $F_n$ das Spektrum ist, das dem vom n-ten Magnetfeldsensor aufgezeichneten Signal entspricht. Die Dimension des Vektors V kann vor der Bildung der Regressionsfunktion reduziert werden, z.B. mit Hilfe von Hauptkomponentenmethoden.

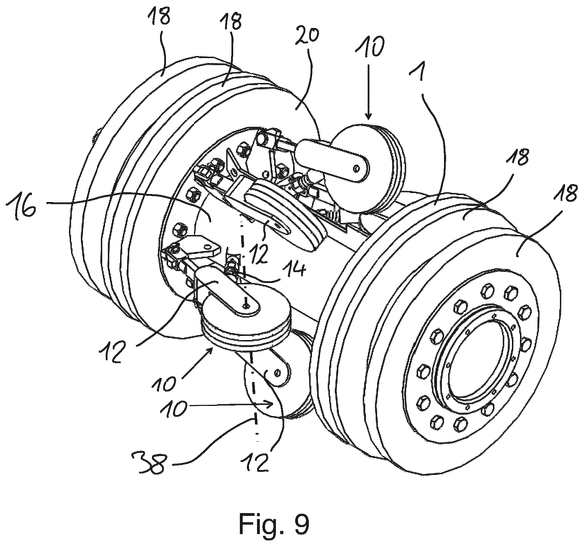

Auf einer Inspektionsvorrichtung können hierzu mehrere Messvorrichtungen mit entsprechenden Magnetisiervorrichtungen 10 und Magnetfeldsensoren insbesondere gemäß dem Ausführungsbeispiel der Figur 9 vorgesehen werden. Eine als Inspektionsmolch ausgebildete Inspektionsvorrichtung weist die Magnetisiervorrichtungen 10 auf, die über jeweilige Halter 12 an der weiteren Inspektionsvorrichtung gehalten sind. Ein jeweiliger Halter 12 wird mittels eines Kraftspeicherelements 14 in Form einer Feder, welches einenends am Halter 12 angeordnet ist und anderenends am Zentralkörper der Inspektionsvorrichtung gelagert ist, im Betrieb gegen die innere Seite bzw. Oberfläche der Wand 1 gedrückt. Der Halter 12 selbst ist schwenkbar am Zentralkörper 16 der Inspektionsvorrichtung angelenkt. Die Magnetisiervorrichtungen 10 rollen aufgrund der magnetischen Wechselwirkung der einzelnen Magneteinheiten mit der Wand 1 der Rohrleitung präzise auf dieser ab, während die Inspektionsvorrichtung durch das in der Rohrleitung befindliche Medium vorangetrieben wird. Hierfür weist die Inspektionsvorrichtung Dichtungselemente in Form von Discs 18 auf, die den inneren, freien Rohrleitungsquerschnitt im Wesentlichen vollständig abdecken. Die Dichtungselemente zentrieren die Inspektionsvorrichtung zusätzlich und führen teilweise zu einer gewissen Reinigung der Rohrleitungswand 1. Über Metallbürsten 20 wird ein Strom in die Wand 1 der Rohrleitung eingespeist, um eine verbesserte Kalibrierung der Ergebnisse vornehmen zu können.

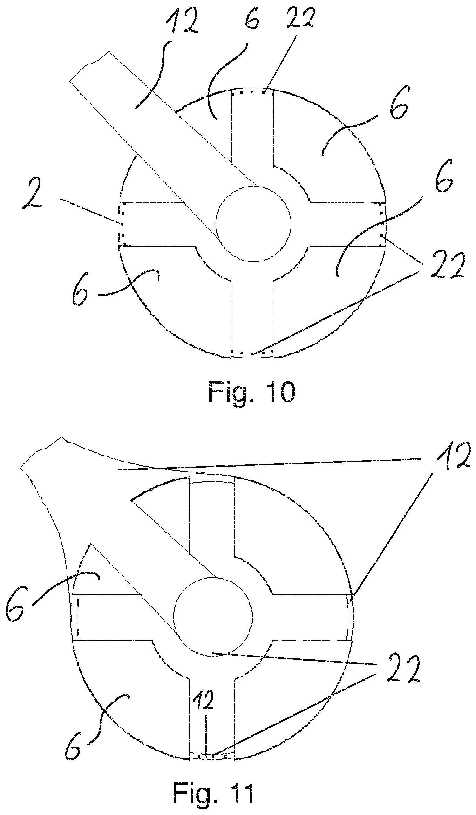

Für die Anordnung von Magnetfeldsensoren gibt es eine Vielzahl verschiedener Möglichkeiten. Gemäß dem Ausführungsbeispiel der Figur 9 ist eine Vielzahl von punktförmig dargestellten Magnetfeldsensoren 22 entlang des Umfangs des Trägers 5 angeordnet. Alternativ sind die Magnetfeldsensoren 22 fest am Halter 12 angeordnet, so dass sich die Magnetfeldsensoren 22 in einem festen Abstand zur inneren Oberseite der Wand 1 bleiben (Fig. 11). Auch Kombinationen dieser Anordnungen sind möglich.

Eine Messvorrichtung, die vorzugsweise Teil der Inspektionsvorrichtung ist, umfasst allgemein für das Auslesen und etwaig notwendige Ansteuern der Sensoren notwendige Elektronik, zugehörige Speicher- und Energieversorgungsmittel.

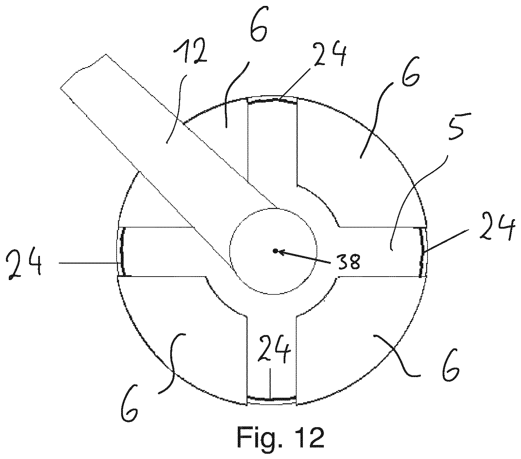

Wiederum alternativ oder ergänzend kann ein Magnetfeldsensor als eine entlang des kompletten Umfangs des Trägers 5 gewickelter Spule ausgebildet sein, indiziert in Figur 12 durch Wicklungen 24.

Ebenfalls liegt es im Rahmen der Erfindung einen fest am Halter 12 angeordneten Magnetfeldsensor 22 mit einem Wicklungen 24 einer Spule aufweisenden Magnetfeldsensor zu kombinieren.

Insbesondere bei einer Messung des Magnetfeldes mittels einer Spule entlang des gesamten Umfangs des Trägers 5 hat diese in Bezug auf den Kontaktpunkt mit der Innenwand immer die gleiche geometrische Konfiguration. Dadurch ist es möglich, die Magnetisiervorrichtung mit dem Magnetfeldsensor vergleichsweise einfach aufzubauen.

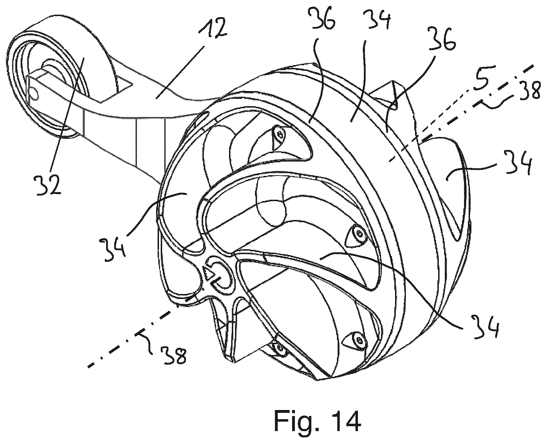

Ein weiteres erfindungsgemäßes Ausführungsbeispiel ist gemäß Fig. 14 mit einem zur Abstützung der Inspektionsvorrichtung an der Rohrleitungswand vorgesehenen Abstützelement 32 in Form eines Rollrades versehen, welches an dem als Befestigungsvorrichtung dienenden Halter 12 drehbar gehalten ist. Der nur gestrichelt indizierte Träger 5 ist über Gleit- und/oder Rollenlager drehbar in einem in dem vorstehenden Ausführungsbeispiel hohlzylinderförmigen Teil 34 des Halters 12 gehalten und von diesem teilweise abgedeckt. Die Drehachsen des Rollrads und des Trägers 5 verlaufen parallel und beide quer zur Rohrleitungslängs- und Fahrtrichtung. Das Rollrad ist das führende Element der Inspektionsvorrichtung, deren Träger 5 spiralförmig von einer Drehachse 38 wegführende Vortriebselemente 34 aufweist. Der Träger 5 ist in einer Ansicht in Richtung der Drehachse 38 mit einem kreisförmigen Umfang versehen, der durch Einfassungen 36 ausgebildet wird. Die vorbeschriebenen Fokussierelemente können in die Einfassungen 36 eingearbeitet sein. Daten- und Energiespeichermittel sind vorzugsweise im Träger 5 angeordnet.

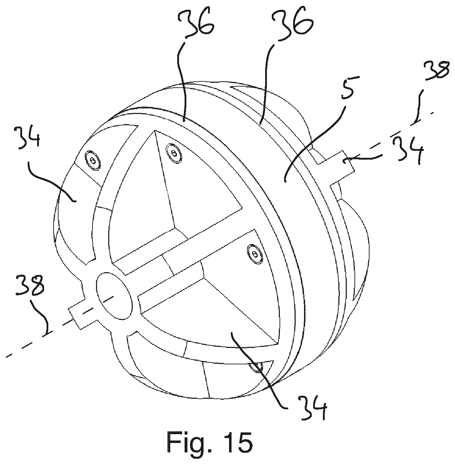

Eine weitere erfindungsgemäße Vorrichtung nach Fig. 15 ist ähnlich der Variante nach Figur 14 mit seitlich abstehenden Vortriebselementen 34 allerdings ohne zusätzliches Stütz- oder Rollrad ausgebildet. Entsprechend ist der Träger 5 auch nicht in einem Halter 12 gelagert. Der Träger 5 weist vorzugsweise ein Setup von Magnetfeldsensoren 12 entsprechend der Anordnung nach den Ausführungsbeispielen der Figuren 10 oder 12 auf. Auch bei dieser Variante sind die Nord-Süd-Achsen der im Träger angeordneten Permanentmagnete parallel zur Drehachse 38 angeordnet.

## Patentansprüche

1.   Verfahren zur Untersuchung des Kathodenschutzes einer ferromagnetischen Rohrleitung, durch

   Erzeugen eines primären magnetischen Wechselfeldes und hiermit einer lokalen Änderung der Permeabilität in einer Wand (1) der Rohrleitung mittels einer Magnetisiervorrichtung (10) einer durch die Rohrleitung bewegten Inspektionsvorrichtung,
   wobei in der Wand (1) der Rohrleitung ein durch einen Gleichstrom des Kathodenschutzes verursachtes sekundäres Gleichstrom-Magnetfeld ausgebildet ist,
   Messung eines resultierenden Magnetfeldes mit einer durch die Rohrleitung bewegten Messvorrichtung, welches sich durch Überlagerung des primären Wechselfeldes und des sekundären Gleichstrom-Magnetfeldes ergibt,
   Analyse der Signalanteile zumindest des sekundären Magnetfelds unter Berücksichtigung der Änderung der Permeabilität in einer EDV-Vorrichtung,
   Ableiten der Größe des Gleichstroms auf Basis der Signalanteile des sekundären Magnetfelds und vorzugsweise auf Basis einer Datenbank mit Kalibrierungsdaten.

2.   Verfahren nach Anspruch 1, **dadurch gekennzeichnet, dass** in der EDV-Vorrichtung das Spektrum des sekundären Magnetfeldes bestimmt wird.

3.   Verfahren nach Anspruch 2, **dadurch gekennzeichnet, dass** in der Analyse für die Bestimmung des Gleichstroms zumindest ein Signalanteil ausgewählt wird, der ein gerades Vielfaches der Frequenz der Richtungsänderung des Magnetfeldes ist.

4.   Verfahren nach einem der vorherigen Ansprüche, **dadurch gekennzeichnet, dass** in der EDV-Vorrichtung auf Basis der Amplitude zumindest eines geraden Vielfachen der Frequenz der Richtungsänderung des Magnetfeldes die Stromstärke mittels einer oder mehrerer Regressionsfunktionen bestimmt wird, vorzugsweise wobei Analysedaten des sekundären Magnetfeldes mittels Analysedaten des primären Magnetfeldes normalisiert und/oder kalibriert werden.

5.   Verfahren nach einem der vorherigen Ansprüche, **dadurch gekennzeichnet, dass** in der EDV-Anlage die Bestimmung der Messbedingungen auf Basis eines Spektrums des primären Wechselfeldes erfolgt.

6.   Verfahren nach einem der vorherigen Ansprüche, **dadurch gekennzeichnet, dass** für einen Messlauf der Inspektionsvorrichtung die Spannung des Kathodenschutzes variiert und zumindest erhöht wird.

7.   Verfahren nach einem der vorherigen Ansprüche, **dadurch gekennzeichnet, dass** für die Bestimmung der Stromstärke eine Vielzahl von Daten eines Messlaufes fusioniert werden.

8. Verfahren nach einem der vorherigen Ansprüche, **dadurch gekennzeichnet, dass** die Messung mit wenigstens einem im Messzeitpunkt zumindest im Wesentlichen in einem festen Abstand zur Wand (1) positionierten Magnetfeldsensor (22) erfolgt, insbesondere wobei der Abstand zumindest einer Magneteinheit der Magnetisiervorrichtung zur Innenseite der Wand (1) variiert.

9. Verfahren nach Anspruch 8, **dadurch gekennzeichnet, dass** die zumindest eine Magneteinheit auf einem Träger (5) in Längsrichtung der Rohrleitung umläuft.

10. Verfahren nach einem der vorherigen Ansprüche, **dadurch gekennzeichnet, dass** während eines Messlaufs innenwandseitig der Rohrleitung durch zwei in Längsrichtung der Rohrleitung beabstandete Kontakte ein Zusatzstrom aufgebracht wird.

11. Inspektionsvorrichtung zur Untersuchung des Kathodenschutzes einer insbesondere ferromagnetischen Rohrleitung, wobei die Inspektionsvorrichtung rohrleitungsgängig und insbesondere mediumgetrieben ausgebildet ist und eine Magnetisiervorrichtung (10) zur Erzeugung eines magnetischen Wechselfeldes und eine wenigstens einen Magnetfeldsensor (22) aufweisende Messvorrichtung zur Messung eines an der Innenseite der Wand (1) der Rohrleitung ausgebildeten Magnetfelds aufweist, **dadurch gekennzeichnet, dass** die Magnetisiervorrichtung (10) wenigstens einen im Betriebsfall durch die Rohrleitung in deren Längsrichtung rollbaren Träger (5) aufweist, der in einem quer zu einer Drehachse (38) verlaufenden Schnitt mit einem vorzugsweise zumindest im Wesentlichen kreisartigen Umfang versehen ist und entlang des Umfangs zumindest zwei Magneteinheiten zur Erzeugung eines magnetischen Wechselfeldes aufweist, deren Magnetfeldrichtungen zumindest teilweise und insbesondere genau einander entgegenlaufen.

12. Inspektionsvorrichtung nach Anspruch 11, **dadurch gekennzeichnet, dass** die Magnetfeldrichtungen der wenigstens einen Magneteinheit parallel oder radial zur Drehachse (38) des Trägers (5) ausgebildet sind.

13. Inspektionsvorrichtung nach Anspruch 11 oder 12, **dadurch gekennzeichnet, dass** entlang des Umfangs des Trägers (5) wenigstens ein Magnetfeldsensor (22) an oder in dem Träger (5) angeordnet ist.

14. Inspektionsvorrichtung nach Anspruch 13, **dadurch gekennzeichnet, dass** der Magnetfeldsensor (22) als Spule mit in Umfangsrichtung verlaufenden Wicklungen (24) ausgebildet ist.

15. Inspektionsvorrichtung nach Anspruch 13, **dadurch gekennzeichnet, dass** entlang des Umfangs eine Vielzahl von Magnetfeldsensoren (22) nebeneinander angeordnet ist.

16. Inspektionsvorrichtung nach einem der Ansprüche 11 bis 15, **dadurch gekennzeichnet, dass** ein Teil der Messvorrichtung in einem zur wandnahen Anordnung ausgebildeten Halter (12) angeordnet ist.

17. Inspektionsvorrichtung nach Anspruch 16, **dadurch gekennzeichnet, dass** der Träger (5) drehbar am Halter (12) gelagert ist.

18. Inspektionsvorrichtung nach einem der Ansprüche 11 bis 17, **dadurch gekennzeichnet, dass** Magnetisiervorrichtung (10) und Magnetfeldsensor (22) relativ zueinander beweglich sind.

19. Inspektionsvorrichtung nach einem der Ansprüche 11 bis 18 unter Einschluss von Anspruch 16, **dadurch gekennzeichnet, dass** der Träger (5) über den Halter (12) mit einem Abstützelement in Form eines Rollrades versehen ist, dessen Durchmesser höchstens 50 % des Durchmessers des Trägers beträgt.

20. Inspektionsvorrichtung nach einem der Ansprüche 11-19, **dadurch gekennzeichnet, dass** die Inspektionsvorrichtung wenigstens eine Disk (18) oder Cup zum Vortrieb aufweist.

21. Inspektionsvorrichtung nach einem der Ansprüche 11-19, **dadurch gekennzeichnet, dass** die Inspektionsvorrichtung wenigstens ein sich insbesondere von der Drehachse (38) wegerstreckendes Vortriebselement (34) aufweist.

**Claims**

1. A method for examining the cathodic protection of a ferromagnetic pipeline, by

   creating a primary alternating magnetic field and thereby a local change in the permeability in a wall (1) of the pipeline by means of a magnetizing device (10) of an inspection device moved through the pipeline, with a secondary DC magnetic field caused by a DC current of the cathodic protection being formed in the wall (1) of the pipeline, using a measuring device moved through the pipeline to measure a resultant magnetic field that emerges from the superposition of the primary alternating field and the secondary DC magnetic field, using a computing device to analyze the signal components of at least the secondary magnetic field giving consideration to the change in the permeability, and deriving the magnitude of the DC current on the basis of the signal components of the secondary magnetic field and preferably on the basis of a database with calibration data.

2. The method as claimed in claim 1, **characterized in that** the spectrum of the secondary magnetic field is determined in the computing device.

3. The method as claimed in claim 2, **characterized in that** at least one signal component which is an even multiple of the frequency of the directional change of the magnetic field is selected in the analysis for determining the DC current.

4. The method as claimed in any of the preceding claims, **characterized in that** the current intensity is determined by means of one or more regression functions in the computing device on the basis of the amplitude of at least one even multiple of the frequency of the directional change of the magnetic field, preferably with analysis data of the secondary magnetic field being normalized and/or calibrated by means of analysis data of the primary magnetic field.

5. The method as claimed in any of the preceding claims, **characterized in that** the measurement conditions are determined in the computing apparatus on the basis of a spectrum of the primary alternating field.

6. The method as claimed in any of the preceding claims, **characterized in that** the voltage of the cathodic protection is varied and at least increased for a measurement run of the inspection device.

7. The method as claimed in any one of the preceding claims, **characterized in that** a multiplicity of data from a measurement run are fused in order to determine the current intensity.

8. The method as claimed in any of the preceding claims, **characterized in that** the measurement is implemented by means of at least one magnetic field sensor (22) which is positioned at least substantially at a fixed distance from the wall (1) at the measurement time, in particular with the distance of at least one magnet unit of the magnetizing device from the inner side of the wall (1) varying.

9. The method as claimed in claim 8, **characterized in that** the at least one magnet unit revolves on a carrier (5) in the longitudinal direction of the pipeline.

10. The method as claimed in any of the preceding claims, **characterized in that**, during a measurement run, an additional current is applied to the inner wall side of the pipeline by two contacts which are spaced apart in the longitudinal direction of the pipeline.

11. An inspection device for examining the cathodic protection of a pipeline, in particular of a ferromagnetic pipeline, the inspection device being formed to be able to pass through the pipeline and in particular be driven by the medium, and comprising a magnetizing device (10) serving to create an alternating magnetic field and a measuring device comprising at least one magnetic field sensor (22) and serving to measure a magnetic field formed on the inner side of the wall (1) of the pipeline, **characterized in that** the magnetizing device (10) comprises at least one carrier (5) which is able to be rolled through the pipeline in the longitudinal direction thereof in an operational state, the said carrier being provided with a preferably at least substantially circular perimeter in a section running transversely to an axis of rotation (38) and, along the perimeter, comprising at least two magnet units for creating an alternating magnetic field, the magnetic field directions of which run at least partially against one another and in particular exactly against one another.

12. The inspection device as claimed in claim 11, **characterized in that** the magnetic field directions of the at least one magnet unit are formed parallel or radially to the axis of rotation (38) of the carrier (5).

13. The inspection device as claimed in claim 11 or 12, **characterized in that**, along the perimeter of the carrier (5), at least one magnetic field sensor (22) is arranged on or in the carrier (5).

14. The inspection device as claimed in claim 13, **characterized in that** the magnetic field sensor (22) is in the form of a coil with windings (24) running in the circumferential direction.

15. The inspection device as claimed in claim 13, **characterized in that** a multiplicity of magnetic field sensors (22) are arranged next to one another along the perimeter.

16. The inspection device as claimed in any of claims 11 to 15, **characterized in that** a part of the measuring device is arranged in a holder (12) designed for arrangement close to the wall.

17. The inspection device as claimed in claim 16, **characterized in that** the carrier (5) is rotatably mounted on the holder (12).

18. The inspection device as claimed in any of claims 11 to 17, **characterized in that** magnetizing device (10) and magnetic field sensor (22) are movable relative to one another.

19. The inspection device as claimed in any of claims 11 to 18 with the inclusion of claim 16, **characterized in that** the carrier (5) is provided via the holder (12) with a supporting element in the form of a roller wheel, the diameter of which is no more than 50% of the diameter of the carrier.

20. The inspection device as claimed in any of claims 11 to 19, **characterized in that** the inspection device comprises at least one disk (18) or cup for propulsion purposes.

21. The inspection device as claimed in any of claims 11 to 190, **characterized in that** the inspection device comprises at least one propulsion element (34) which extends away from the axis of rotation (38) in particular.

**Revendications**

1. Procédé d'examen de la protection cathodique d'une canalisation ferromagnétique, par

production, au moyen d'un dispositif de magnétisation (10) d'un dispositif d'inspection déplacé dans la canalisation, d'un champ magnétique alternatif primaire et ainsi, d'une variation locale de la perméabilité dans une paroi (1) de la canalisation, un champ magnétique continu secondaire provoqué par un courant continu de la protection cathodique étant induit dans la paroi (1) de la canalisation, par mesure, à l'aide d'un dispositif de mesure déplacé dans la canalisation, d'un champ magnétique résultant issu de la superposition du champ alternatif primaire et du champ magnétique continu secondaire,
par analyse, dans un dispositif de traitement électronique de données, des composantes de signaux d'au moins le champ magnétique secondaire, compte tenu de la variation de la perméabilité,
par déduction de l'amplitude du courant continu sur la base des composantes de signaux du champ magnétique secondaire, et de préférence à partir d'une base de données contenant des données d'étalonnage.

2. Procédé selon la revendication 1, **caractérisé en ce que** le spectre du champ magnétique secondaire est déterminé dans le dispositif de traitement électronique de données.

3. Procédé selon la revendication 2, **caractérisé en ce que**, dans l'analyse, au moins une composante de signal est sélectionnée pour la détermination du courant continu, laquelle est un multiple pair de la fréquence du changement de direction du champ magnétique.

4. Procédé selon l'une quelconque des revendications précédentes, **caractérisé en ce que**, dans le dispositif de traitement électronique de données, l'intensité du courant est déterminée sur la base de l'amplitude d'au moins un multiple pair de la fréquence du changement de direction du champ magnétique, au moyen d'une ou de plusieurs fonctions de régression, les données d'analyse du champ magnétique secondaire étant de préférence normalisées et/ou étalonnées au moyen de données d'analyse du champ magnétique primaire.

5. Procédé selon l'une quelconque des revendications précédentes, **caractérisé en ce que**, dans l'installation de traitement électronique de données, la détermination des conditions de mesure est effectuée sur la base d'un spectre du champ magnétique alternatif primaire.

6. Procédé selon l'une quelconque des revendications précédentes, **caractérisé en ce que** la tension de la protection cathodique est amenée à varier et au moins augmentée pour un cycle de mesure du dispositif d'inspection.

7. Procédé selon l'une quelconque des revendications précédentes, **caractérisé en ce qu'**une pluralité de données d'un cycle de mesure sont fusionnées pour la détermination de l'intensité du courant.

8. Procédé selon l'une quelconque des revendications précédentes, **caractérisé en ce que** la mesure est effectuée à l'aide d'au moins un capteur de champ magnétique (22) positionné au moins sensiblement à une distance fixe de la paroi (1) au moment de la mesure, la distance d'au moins une unité magnétique du dispositif de magnétisation par rapport à la face intérieure de la paroi (1) étant en particulier amenée à varier.

9. Procédé selon la revendication 8, **caractérisé en ce que** ladite au moins une unité magnétique circule sur un support (5) dans la direction longitudinale de la canalisation.

10. Procédé selon l'une quelconque des revendications précédentes, **caractérisé en ce que**, pendant un cycle de mesure, un courant supplémentaire est appliqué du côté de la paroi intérieure de la canalisation par l'intermédiaire de deux contacts espacés dans la direction longitudinale de la canalisation.

11. Dispositif d'inspection destiné à l'examen de la protection cathodique d'une canalisation notamment ferromagnétique, le dispositif d'inspection étant conçu pour se déplacer dans la canalisation et étant en particulier entraîné par un fluide et comportant un dispositif de magnétisation (10) destiné à générer un champ magnétique alternatif et un dispositif de mesure comportant au moins un capteur de champ magnétique (22) destiné à mesurer un champ magnétique créé sur la face intérieure de la paroi (1) de la canalisation, **caractérisé en ce que** le dispositif de magnétisation (10) comporte au moins un support (5) apte à rouler dans la canalisation dans sa direction longitudinale en fonctionnement, lequel support présente, dans une section s'étendant transversalement à un axe de rotation (38), une circonférence de préférence au moins sensiblement circulaire et présente, le long de ladite circonférence, au moins deux unités magnétiques destinées à générer un champ magnétique alternatif, dont les directions de champ magnétique sont au moins partiellement, et en particulier exactement opposées.

12. Dispositif d'inspection selon la revendication 11, **caractérisé en ce que** les directions du champ magnétique de ladite au moins une unité magnétique sont conçues pour être parallèles ou radiales par rapport à l'axe de rotation (38) du support (5).

13. Dispositif d'inspection selon la revendication 11 ou 12, **caractérisé en ce qu'**au moins un capteur de champ magnétique (22) est disposé le long de la circonférence du support (5), sur ou dans le support (5).

14. Dispositif d'inspection selon la revendication 13, **caractérisé en ce que** le capteur de champ magnétique (22) est conçu sous la forme d'une bobine dotée d'enroulements (24) s'étendant dans la direction circonférentielle.

15. Dispositif d'inspection selon la revendication 13, **caractérisé en ce qu'**une pluralité de capteurs de champ magnétique (22) sont disposés côte à côte le long de la circonférence.

16. Dispositif d'inspection selon l'une quelconque des revendications 11 à 15, **caractérisé en ce qu'**une partie du dispositif de mesure est disposée dans un élément de maintien (12) conçu pour un agencement proche de la paroi.

17. Dispositif d'inspection selon la revendication 16, **caractérisé en ce que** le support (5) est monté rotatif sur l'élément de maintien (12).

18. Dispositif d'inspection selon l'une quelconque des revendications 11 à 17, **caractérisé en ce que** le dispositif de magnétisation (10) et le capteur de champ magnétique (22) sont mobiles l'un par rapport à l'autre.

19. Dispositif d'inspection selon l'une quelconque des revendications 11 à 18, y compris la revendication 16, **caractérisé en ce que** le support (5) est muni, par l'intermédiaire de l'élément de maintien (12), d'un élément d'appui sous la forme d'une roue de roulement dont le diamètre est au plus égal à 50 % du diamètre du support.

**20.** Dispositif d'inspection selon l'une quelconque des revendications 11 à 19, **caractérisé en ce que** le dispositif d'inspection comporte au moins un disque (18) ou une coupelle pour la propulsion.

**21.** Dispositif d'inspection selon l'une quelconque des revendications 11 à 19, **caractérisé en ce que** le dispositif d'inspection comporte au moins un élément de propulsion (34) qui s'étend en particulier en sens opposé à l'axe de rotation (38).

Fig 1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2014096942 A2
- WO 2019156584 A1